# EUROPEAN PATENT SPECIFICATION

(11) **EP 2 821 797 B1**
(45) Date of publication and mention of the grant of the patent: **04.11.2020**
(21) Application number: 13003381.4
(22) Date of filing: 03.07.2013
(51) Int. Cl.: G01R 15/18

(54) **Current sensing device, and method of manufacturing the same**
Stromsensorvorrichtung und Verfahren zu ihrer Herstellung
Dispositif de détection de courant et son procédé de fabrication

(43) Date of publication of application: 07.01.2015
(73) Proprietor: ABB Schweiz AG, 5400 Baden (CH)
(72) Inventor: Javora, Radek, 664 62 Hrusovany u Brna (CZ); Podzemny, Jaromir, 621 00 Brno (CZ); Velesik, Petr, 602 00 Brno (CZ)
(74) Representative: Maiwald Patent- und Rechtsanwaltsgesellschaft mbH

(56) References cited:
- WO-A1-2013/093516
- US-A1- 2011 148 561

## Description

The invention relates to a current sensing device with at least two current sensors, implemented in an openable ringshaped support, and a method of making the same, according to the preamble of claims 1 and 9.

Actual current sensor systems used for split-core current sensing devices uses basically three constructional features.

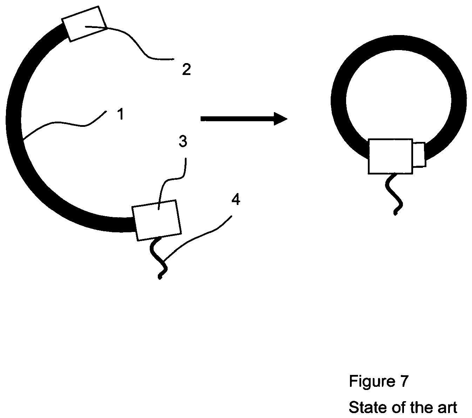

First is a flexible current sensing device, like shown in figure 7 (state of the art), with openable locking mechanism consists of a flexible coil, a male locking part, a female locking part and output cable.

The US patent application US 2011/0148561 A1 discloses a current sensing device with a closed ring support element. In the WO 2013/093516 A1 is disclosed a ringchain shaped flexible current sensor.

This concept allows very easy assembly but have disadvantages in worse accuracy caused by not exactly round and stable shape.

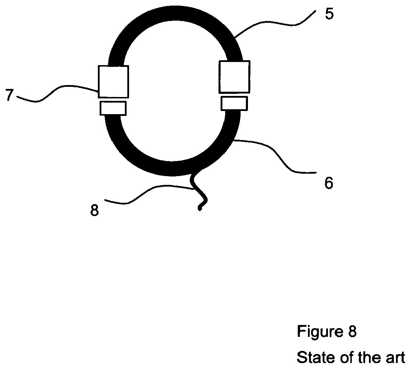

Measurement devices like shown in figure 8 made generally from two solid halves which are electrically interconnected by some type of connector, to achieve closed internal circuit and output cable . This concept allows both good accuracy and easy assembly but for significantly higher price and more complex design.

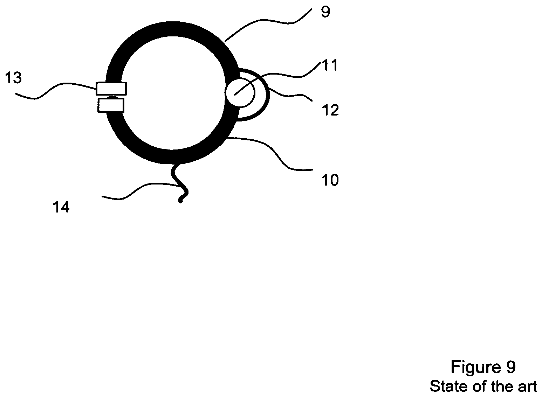

Measurement devices like shown in figure 9, made generally from two solid halves assembled together using a hinge and electrically interconnected by some type of cable placed outside of device body to achieve closed internal circuit, a locking system and an output cable. This concept allows both good accuracy and easy assembly on measured line but for higher price, more complex design and increased risk of interconnecting cable damage.

In order to use this already basical features for current sensors, it is the object of the invention, to optimize the current sensor device in the structural shape, in order to enhance the manufacturing, by resulting high accuracy.

This is realised by the invention, with the features of claim 1.

Further embodiments are given by the depending claims 2 to 8.

A method of manufacture of such a current sensor device is given by the features of claim 9.

Further embodiments to that are disclosed in the further depending claims.

The basical idea of the invention is, that more than two current sensors are arranged in a chain-like arrangement in the ringshaped support, and that the current sensors are electrically connected in series.

In an advantageous embodiment, the current sensors are at least partly linear coils, which are connected in series like aforesaid.

A further advantageous embodiment is, that the ringshaped support is divided into two halfring-elements, which are mechanically connected by a hinge.

So this results in that it consists of the chain of at least partly linear coils connected in series, which enables opening of the said device at least between the first and the last linear coil and allows flexibility of the remaining part in order to do the required opening without disconnecting the circuit to be measured.

Furthermore advantageous is, that the electrical continuous interconnection between a first group of current sensors in a first half-halfring element and a second group of current sensors in a second halfring-element is provided by interconnection cables, which are dimensioned in its length as such, that it releases a reservoir length of the interconnecting cables during the opening of the current sensor device ring via the hinge.

In a further advantageous embodiment, the linear coils are arranged in such, that they have equal gap between each of them.

A further advantageous embodiment is, that the ring-shaped support together with the arranged current sensors on that are covered by a correspondingly also ring shaped housing, and that the housing of said linear coils is either made of at least partly conductive material or has at least partly conductive inner or outer surface treatment.

A further advantageous embodiment is, that the ring shaped housing is functionally the aforesaid support of the current sensor arrangement, and the housing itself is devided into the aforesaid two halfring elements, mechanically connected by the hinge.

According to a wireing, which support the invention in an advantageous way, the return conductor is going backwards from the last to the first coil through the center of each coil in the chain arrangement of the coils or at least arround each coil.

In order to support the aforesaid inventive construction, the sensing device furthermore could be either flexible in shape so it can be at least partly bended in each space between each coil or it can be made as rigid solution having at least two separable parts with at least one connecting point connecting the internal wires and coils together.

Alternatively the coils could have either ferromagnetic core or the core material may be any kind of non-magnetic material.

The advantages in detail are described below in context with the figures.

According to the method of manufacture such a current sensor device, the basical features of the invention are, that the sensing device is based on the use of rogowski coil principle, using at least two linear coils connected in series which allows division of the said device between the said coils and have openable design by the use of a sealing and wire positioning system such, that it seals a main cavity in each part of said device during potting by protective and fixation material which avoids the leakage of such material around interconnecting wires by using a combination of thin sockets and sealing pins, used during potting by lower viscosity material, which also position the interconnecting wires close to the center of the cavity designed for the wire loop protection.

In a further advantageous embodiment of the method is said, that for higher viskosity material the sealing pins may not be used and/or sockets can be shortened.

A further advantageous embodiment is, that it is designed for minimum prolongation of interconnecting wires during opening of said sensing device by positioning the hinge rotary axis as close as possible to the outer diameter of said sensing device.

Furthermore it is said, that it consists of flat part and rotary pin which is part of said hinge.

The invention is shown in figure 1 to 6

State of the art is shown in figures 7 to 9.
- Figure 1:: upper part: Current sensing device consisting of the chain of linear coils lower part: Current sensing device with housing
- Figure 2:: perspective view on current sensing device
- Figure 3:: upper part: housing of the current sensing device lower part: detail of the hinge
- Figure 4:: detail of the hinge with cable arrangement
- Figure 5:: detailed view into the hinge from perspective view
- Figure 6:: detail of the hinge and the cable arrangement
- Figure 7:: state of the art
- Figure 8:: state of the art
- Figrue 9:: state of the art

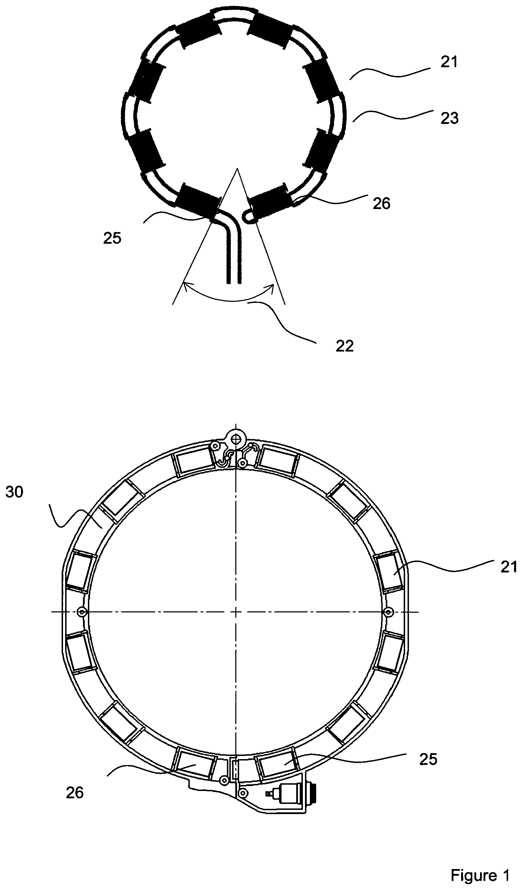

Figure 1 displays an embodiment of the invention, in which the openable or split-core current sensing device construction, optimized from shape, manufacturing, assembly and ergonomy point of view, is shown. Openable design of a current sensing device, concerning to the invention, provides advantage of mounting this device directly on desired measurement place without the need of circuit disassembly. Construction of this openable current sensing device could be solid or at least partly flexible to achieve the best accuracy of measured values.

In the upper part of figure 1, the proposed solution is using a chain of small coils 21 connected in series with an equal gap 22 in between each of the coils.

In order to achieve the best accuracy, it is very important to keep symmetry, i.e. the same gap or distance 22 between each linear coil 21. In case good symmetry is achieved, excellent results on measurement accuracy will be noticed.

In order to reduce the effect of stray magnetic fields, it is worth to use return conductor 23 going from the last coil 26 back to the first one 25 through the centre of each coil in the chain. In order to make the openable current sensing device, it is advantageous to have the opening between the first linear coil 25 and the last linear coil 26 in the chain of these coils as there do not need to be any wires directly between them.

The lower part of figure 1 shows the inventive construction commonly with the concerning housing, which follows the basical mechanical distribution or location of the several coils like shown in the upper part of figure 1.

As it would be more complex to shield each individual coil and wires from external disturbances, it is advantageous to use a housing 30, like shown in the lower part of figure 1, for said coils made of some at least partly conductive material or having a conductive surface treatment or additional shielding material arround the housing.

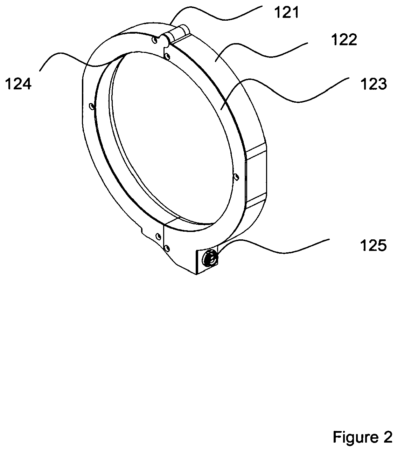

Figure 2 shows the sensor housing already displayed in figure 1 in a perspective view. Shown is the openable current sensing device construction optimized from shape, manufacturing, assembly and ergonomy point of view, like already pointed out above. Openable design of the current sensing device, like already said before, provides advantages of mounting this device directly on desired measurement place without need of circuit dismontle. Construction of this openable current sensing device is solid to achieve high accuracy of measured values. Construction of device frame should be from thermoplastic, thermoset or metal material with electrical shielding treatment or material own shielding properties. Measuring element based on Rogowski coil contains from various number of small linear coils which allows to easy implement dividing plane between two of this linear coils. Both halves of the openable current sensing device use hinge for mechanical and wires for electrical interconnection and also provides protection to interconnecting wires hiden inside. Number of used parts is lowered by grouping of functions and overall design is made with respect to easy production and assembly process. Locking system and the hinge are integral part of the both halves. Both fixed or detachable cable should be used in this design.

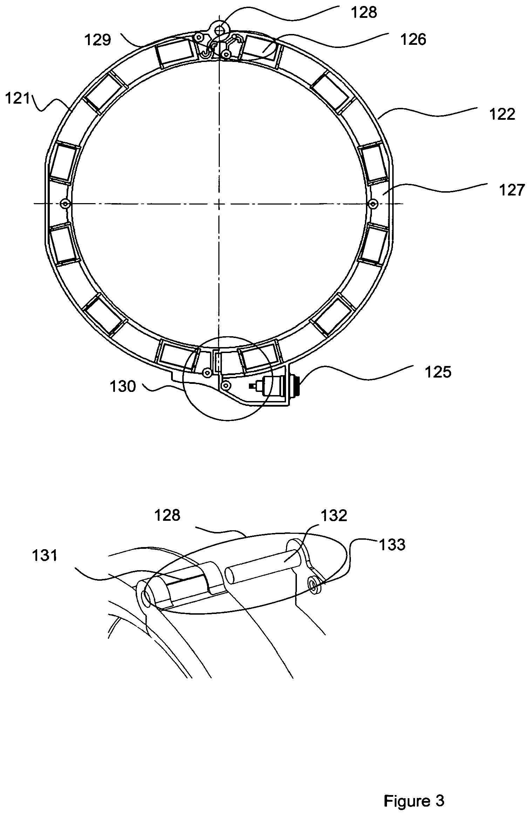

Invented openable current sensing device consists of two basic parts 121, 122 made as shell from thermoplastic, thermoset or metal material with electrical shielding treatment or material own shielding properties, two cover parts 123, 124, like shown in figure 3, from the same material or material with simillar shielding properties which combines a function of electrical field shield, mechanical protection and the hinge 128 pin 132 in figure 3, as well as the output connector or fixed cable 125, current sensing element 126 based on Rogowski coil principle and potting material 127 filled into both basic parts 121, 122 of said sensing device for the sensing element 126 fixation and mechanical protection.

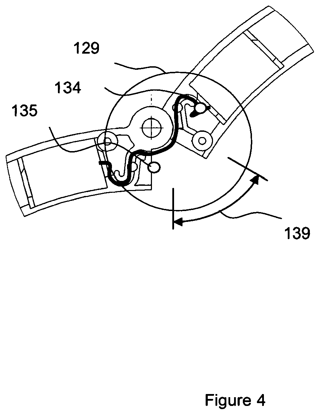

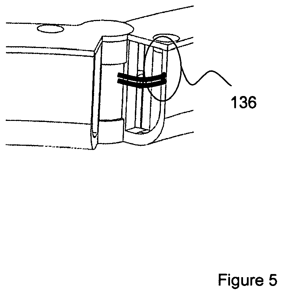

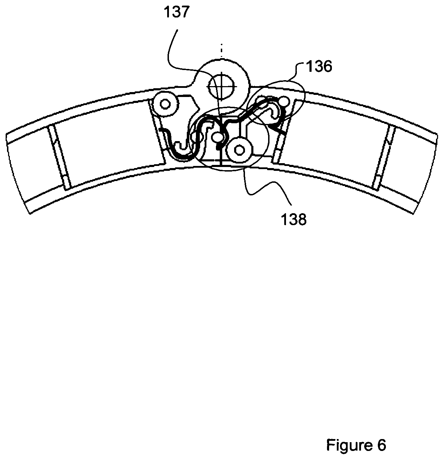

In figure 3 in the lower part, which displays the details of the hinge 128, both basic parts of said sensing device are joined together by hinge 128 equipped with stop 131 which should be designed to various opening angle 139 in order to avoid damage of interconnecting wires 134 leading through sealing system 129 and sealed and positioned to the center of said basic parts 121, 122 (bottom of sealing canal 136) by sealing pins 135, which are shown in figure 4, 5 and 6 in futher more detailed view. Wires are assembled in device open position and if device is closed then wires are bended to the loop 137 which dimensions are smaller than available space in the non casted cavity 138 under the hinge. If the said sensing device is closed, all parts of sensing circuit are covered by the said two basic parts and two cover parts 121, 122, 123, 124 to ensure the proper function of the said sensing device. Close position is ensured by clamp on system 130. This gap or opening angle 22 is importantly also realized between the first and the last coil. That is quite important to be able to use interconnected wires only on one side.

The state of the art is shown in figures 7 to 9.

The actually known and used systems for divided sensing devices uses basically three construction systems.

A flexible current sensing device shown in figure 7 (state of the art), is used with openable locking mechanism which consists of flexible coil 1, male locking part 2, female locking part 3 and output cable 4.

This concept allows very easy assembly but have disadvantages in worse accuracy caused by not exactly round and stable shape.

A measurement device, like shown in figure 8 (state of the art), is made generally from two solid halves 5, 6 electrically interconnected by some type of connector 7 to achieve closed internal circuit and output cable 8 . This concept allows both good accuracy and easy assembly but for significantly higher price and more complex design.

A measurement device, like shown in figure 9, is made generally from two solid halves 9, 10 assembled together using hinge 11 and electrically interconnected by some type of cable 12 placed outside of device body to achieve closed internal circuit, locking system 13 and output cable 14. This concept allows both good accuracy and easy assembly on measured line but for higher price, more complex design and increased risk of interconnecting cable damage.

As conclusive description of the invention, adjacently to the state of the art, it can pointed out, that the conventional solution of openable flexible Rogowski coil (RC) that is continuously wound on usually flexible former with discontinuity between the beginning and the end, which cause problems in achieving good accuracy. Shielding is usually done by additional layer and is covered by some insulation. This is the fact by the state of the art, like shown.

In contrary to that, the invention is different in the sense that rogowski coils according to this invention consist of several small linear coils, where the gap between the coils is regularly distributed. Such construction enables achieving high accuracy and is the best construction in case the opening is required. Opening is done between the first and the last coil and thus has no negative effect on accuracy and position of primary conductor inside the coil. Shielding is done by semiconductive or conductive cover itself, which serves in the same time as positioning means for the linear coils.

Main point according to the method of manufacture and the positioning of the functional details for opening the sensor device is to describe the system of positioning the internal wires and hinge, which should enable easy and reliable opening, but in the same time protecting the wires from being damaged. It is also designed in the way that filling material will not leak out during potting process, so it is easily manufacturable.

So the first proposal is focusing more on linear coils design, despite the second one is describing the opening ability and construction of the cover to enable opening and easy production, as well as the manufactural aspects.

**Reference signs**
- 1: flexible coil (state of the art)
- 2: male locking part (state of the art)
- 3: female locking part (state of the art)
- 4: output cable (state of the art)
- 5: solid halves (state of the art)
- 6: solid halves (state of the art)
- 7: connector (state of the art)
- 8: output cable (state of the art)
- 9: solid halves (state of the art)
- 10: solid halves (state of the art)
- 11: hinge (state of the art)
- 12: cable (state of the art)
- 13: locking system (state of the art)
- 14: output cable (state of the art)
21 small coils
22 equal gap or distance
23 return conductor
25 first linear coil (in the chain arrangement of a series of coils)
26 last linear coil (in the chain arrangement of a series of coils)
30 housing
121 basic part
122 basic part
123 cover part
124 cover part
125 output connector or fixed cable
126 sensing element
127 potting material
128 hinge 129 sealing system
130 clamp on system
131 stop, stopping element
132 pin
134 interconnecting wires
135 sealing pins
136 sealing canal
137 loop
138 non casted cavity
139 opening angle

## Claims

1. Current sensing device with at least two current sensors (21), implemented in an openable ringshaped support, wherein more than two current sensors are arranged in a chain-like arrangement in the ringshaped support, and that the current sensors are electrically connected in series,
**characterized in**
**that** the ringshaped support is divided into two halfring-elements, which are mechanically connected by a hinge (128), and that the electrical continuous interconnection between a first group of current sensors in a first halfring element and a second group of current sensors in a second halfring-element is provided by interconnection cables (134), which are dimensioned in length such that reservoir length, in the form of a loop (137), of the interconnecting cables is released during the opening of the current sensor device ring via the hinge.

2. Current sensing device according to claim 1,
**characterized in**
**that** the current sensors are coils, which extend linearly and which are connected in series.

3. Current sensing device according to claim 1,
**characterized in**
**that** the coils are arranged such that they have equal gaps (22) between each of them.

4. Current sensing device according to claim 3,
**characterized in**
**that** the ring-shaped support together with the arranged current sensors on that are covered by a correspondingly also ring shaped housing (30), and that the housing of said coils is either made of at least partly conductive material or has at least partly conductive inner or outer surface treatment.

5. Current sensing device according to claim 4,
**characterized in**
**that** the ring shaped housing is functionally the aforesaid support of the current sensor arrangement, and that the housing itself is divided into the aforesaid two halfring elements, mechanically connected by the hinge.

6. Current sensing device according to one of the aforesaid claims,
**characterized in**
**that** the the return conductor is going backwards from the last to the first coil through the center of each coil in the chain arrangement of the coils or at least arround each coil.

7. Current sensing device according to one of the aforesaid claims,
**characterized in**
**that** the sensing device could be either flexible so it can be at least partly bended in each space between each coil or it can be made as a rigid solution having at least two separable parts with at least one connecting point connecting the internal wires and coils together.

8. Current sensing device according to one of the aforesaid claims,
**characterized in**
**that** the coils could have either a ferromagnetic core or core material of non-magnetic material.

9. Method of manufacture a current sensor device according to at least one of the claims 1 to 8,
**characterized in,**
**that** the sensing device is based on the use of the rogowski coil principle, using at least two coils (126) connected in series which allows division of the said device between the said coils and having an openable design by the use of a sealing and wire positioning system that seals a main cavity in each halfring of said device during potting by a protective and fixation material (127) and which avoids the leakage of such material around interconnecting wires (134) by using a combination of sockets (136) and sealing pins (135), used during potting by lower viscosity material, and which also position the interconnecting wires in a non casted cavity (138) designed for the wire loop (137) protection.

10. Method according to claim 9,
**characterized in,** tha
t for higher viscosity material during potting the sealing pins (135) may not be used and/or sockets (136) can be shortened.

11. Method according to claim 9,
**characterized in,**
**that** it is designed for minimum prolongation of the interconnecting wires (134) to protect them from damage during opening of said sensing device by positioning the hinge (128) rotary axis as close as possible to the outer circumference of said sensing device.

12. Method according to claim 9,
**characterized in,**
**that** the hinge (128) consists of a flat part (133) and a rotary pin (132).

## Patentansprüche

1. Stromerfassungsvorrichtung mit mindestens zwei Stromsensoren (21), die in einem öffnungsfähigen, ringförmigen Träger implementiert sind, wobei mehr als zwei Stromsensoren in einer kettenartigen Anordnung in dem ringförmigen Träger angeordnet sind und die Stromsensoren in Reihe elektrisch verbunden sind,
**dadurch gekennzeichnet, dass**
der ringförmige Träger in zwei Halbringelemente unterteilt ist, die durch ein Gelenk (128) mechanisch verbunden sind,
und dass die ununterbrochene elektrische Kopplung zwischen einer ersten Gruppe Stromsensoren in einem ersten Halbringelement und einer zweiten Gruppe Stromsensoren in einem zweiten Halbringelement durch Kopplungskabel (134) bereitgestellt wird, deren Länge derart bemessen ist, dass während des Öffnens des Stromsensorvorrichtungsrings über das Gelenk eine Reservelänge in Form einer Schleife (137) der Kopplungskabel freigegeben wird.

2. Stromsensorvorrichtung nach Anspruch 1,
**dadurch gekennzeichnet, dass** die Stromsensoren Spulen sind, die sich geradlinig erstrecken und die in Reihe geschaltet sind.

3. Stromsensorvorrichtung nach Anspruch 1,
**dadurch gekennzeichnet, dass**
die Spulen derart angeordnet sind, dass zwischen jeder von ihnen gleiche Zwischenräume (22) vorhanden sind.

4. Stromsensorvorrichtung nach Anspruch 3,
**dadurch gekennzeichnet, dass**
der ringförmige Träger zusammen mit den darauf angeordneten Stromsensoren durch ein entsprechend ebenfalls ringförmig geformtes Gehäuse (30) abgedeckt ist,
und dass das Gehäuse der Spulen entweder aus einem zumindest teilweise leitfähigen Material hergestellt ist oder eine zumindest teilweise leitfähige Innen- oder Außenflächenbehandlung aufweist.

5. Stromsensorvorrichtung nach Anspruch 4,
**dadurch gekennzeichnet, dass**
das ringförmige Gehäuse funktional der vorher genannte Träger der Stromsensoranordnung ist und dass das Gehäuse selbst in die vorher genannten zwei Halbringelemente unterteilt ist, die durch das Gelenk mechanisch verbunden sind.

6. Stromsensorvorrichtung nach einem der vorhergehenden Ansprüche,
**dadurch gekennzeichnet, dass**
der Rückleiter von der letzten bis zur ersten Spule durch die Mitte jeder Spule in der Kettenanordnung der Spulen oder zumindest um jede Spule zurück verläuft.

7. Stromsensorvorrichtung nach einem der vorhergehenden Ansprüche,
**dadurch gekennzeichnet, dass**
die Erfassungsvorrichtung entweder flexibel sein kann, derart, dass sie in jedem Raum zwischen jeder Spule zumindest teilweise gebogen werden kann, oder dass sie als eine steife Lösung hergestellt sein kann, die mindestens zwei trennbare Komponenten aufweist, wobei mindestens ein Verbindungspunkt die internen Drähte und Spulen miteinander verbindet.

8. Stromsensorvorrichtung nach einem der vorhergehenden Ansprüche,
**dadurch gekennzeichnet, dass**
die Spulen entweder einen ferromagnetischen Kern oder ein Kernmaterial aus einem nichtmagnetischen Material aufweisen könnten.

9. Verfahren zum Herstellen einer Stromsensorvorrichtung nach mindestens einem der Ansprüche 1 bis 8,
**dadurch gekennzeichnet, dass**
die Erfassungsvorrichtung auf der Verwendung des Rogowski-Spulenprinzips unter Verwendung mindestens zweier in Reihe geschalteter Spulen (126) beruht, was eine Teilung der Vorrichtung zwischen den Spulen ermöglicht, und eine öffnungsfähige Konstruktion unter Verwendung eines Dichtungs- und Drahtanordnungssystems aufweist, das einen Haupthohlraum in jedem Halbring der Vorrichtung während des Vergießens durch ein Schutz- und Befestigungsmaterial (127) abdichtet und das das Austreten von derartigem Material um die Kopplungsdrähte (134) unter Verwendung einer Kombination von Sockeln (136) und Dichtungsstiften (135), die während des Vergießens durch ein Material mit geringerer Viskosität verwendet wird, vermeidet, und das außerdem die Kopplungsdrähte in einem nicht vergossenen Hohlraum (138) anordnet, der zum Schutz der Drahtschleife (137) ausgelegt ist.

10. Verfahren nach Anspruch 9,
**dadurch gekennzeichnet, dass**
für ein Material mit höherer Viskosität während des Vergießens die Dichtungsstifte (135) nicht verwendet werden müssen und/oder die Sockel (136) gekürzt werden können.

11. Verfahren nach Anspruch 9,
**dadurch gekennzeichnet, dass**
es für eine minimale Dehnung der Kopplungsdrähte (134) ausgelegt ist, um sie vor Beschädigung während des Öffnens der Erfassungsvorrichtung zu schützen, indem die Drehachse des Gelenks (128) so nah wie möglich am Außenumfang der Erfassungsvorrichtung angeordnet wird.

12. Verfahren nach Anspruch 9,
**dadurch gekennzeichnet, dass**
das Gelenk (128) aus einer flachen Komponente (133) und einem Drehstift (132) besteht.

## Revendications

1. Dispositif de détection de courant avec au moins deux capteurs de courant (21), mis en œuvre dans un support en forme d'anneau ouvrant, plus de deux capteurs de courant étant agencés dans un agencement de type chaîne dans le support en forme d'anneau, et les capteurs de courant étant branchés électriquement en série,
**caractérisé**
**en ce que** le support en forme d'anneau est divisé en deux éléments semi-annulaires, qui sont reliés mécaniquement par une charnière (128),
et **en ce que** l'interconnexion électrique continue entre un premier groupe de capteurs de courant dans un premier élément semi-annulaire et un deuxième groupe de capteurs de courant dans un deuxième élément semi-annulaire est assurée par des câbles d'interconnexion (134) qui sont dimensionnés en longueur de telle sorte qu'une longueur de réserve, sous la forme d'une boucle (137), des câbles d'interconnexion est libérée pendant l'ouverture de l'anneau de dispositif de détection de courant par le biais de la charnière.

2. Dispositif de détection de courant selon la revendication 1,
**caractérisé**
**en ce que** les capteurs de courant sont des bobines, qui s'étendent linéairement et qui sont branchées en série.

3. Dispositif de détection de courant selon la revendication 1,
**caractérisé**
**en ce que** les bobines sont agencées de telle sorte qu'elles ont des espaces (22) égaux entre chacune d'entre elles.

4. Dispositif de détection de courant selon la revendication 3,
**caractérisé**
**en ce que** le support en forme d'anneau, conjointement avec les capteurs de courant agencés sur celui-ci, est recouvert par un boîtier corrélativement aussi en forme d'anneau (30),
et **en ce que** le boîtier desdites bobines est constitué d'un matériau au moins partiellement conducteur ou présente un traitement de surface interne ou externe au moins partiellement conducteur.

5. Dispositif de détection de courant selon la revendication 4,
**caractérisé**
**en ce que** le boîtier en forme d'anneau est fonctionnellement le support susmentionné de l'agencement de capteurs de courant, et en ce que le boîtier lui-même est divisé en les deux éléments semi-annulaires susmentionnés, reliés mécaniquement par la charnière.

6. Dispositif de détection de courant selon une des revendications précédentes,
**caractérisé**
**en ce que** le conducteur de retour revient en arrière de la dernière à la première bobine par le centre de chaque bobine dans l'agencement de chaîne des bobines ou au moins autour de chaque bobine.

7. Dispositif de détection de courant selon une des revendications précédentes,
**caractérisé**
**en ce que** le dispositif de détection pourrait être souple, de sorte qu'il pourrait être au moins partiellement plié dans chaque espace entre chaque bobine ou qu'il pourrait être fabriqué sous la forme d'une solution rigide ayant au moins deux parties séparables avec au moins un point de branchement branchant ensemble les fils internes et les bobines.

8. Dispositif de détection de courant selon une des revendications précédentes,
**caractérisé**
**en ce que** les bobines pourraient avoir un noyau ferromagnétique ou un matériau de noyau en matériau amagnétique.

9. Procédé de fabrication d'un dispositif de détection de courant selon au moins une des revendications 1 à 8,
**caractérisé**
**en ce que** le dispositif de détection est basé sur l'utilisation du principe de la bobine de Rogowski, utilisant au moins deux bobines (126) branchées en série, ce qui permet la division dudit dispositif entre lesdites bobines, et ayant une conception ouvrante par l'utilisation d'un système de scellement et de positionnement de fil qui scelle une cavité principale dans chaque demi-anneau dudit dispositif pendant l'empotage par un matériau protecteur et de fixation (127) et qui évite la fuite de ce matériau autour de fils d'interconnexion (134) au moyen d'une combinaison de douilles (136) et de tenons de scellement (135), utilisés pendant l'empotage par un matériau de viscosité inférieure, et qui positionne également les fils d'interconnexion dans une deuxième cavité non coulée (138) conçue pour la protection de la boucle de fil (137).

10. Procédé selon la revendication 9,
**caractérisé**
**en ce qu'**un matériau de plus grande viscosité pendant l'empotage des tenons de scellement (135) peut ne pas être utilisé et/ou les douilles (136) peuvent être raccourcies.

11. Procédé selon la revendication 9,
**caractérisé**
**en ce qu'**il est conçu pour une prolongation minimale des fils d'interconnexion (134) pour les protéger d'un endommagement pendant l'ouverture dudit dispositif de détection par positionnement de l'axe de rotation de la charnière (128) aussi près que possible de la circonférence externe dudit dispositif de détection.

12. Procédé selon la revendication 9,
**caractérisé**
**en ce que** la charnière (128) est composée d'une partie plate (133) et d'une broche rotative (132).
